# EUROPEAN PATENT APPLICATION

(11) **EP 4 761 529 A1**
(43) Date of publication of application: **17.06.2026**
(21) Application number: 24860322.7
(22) Date of filing: 22.08.2024
(51) Int. Cl.: H10H 20/841, H10H 20/82, H10H 29/20, H10W 29/00, H10D 86/00

(54) **LIGHT-EMITTING ELEMENT, MANUFACTURING METHOD THEREOF, AND DISPLAY DEVICE USING SAME**

(30) Priority: 25.08.2023 KR 20230111877
(71) Applicant: LG Electronics Inc., Yeongdeungpo-gu Seoul 07336 (KR)
(72) Inventor: JEON, Jina, Seoul 06772 (KR); LEE, Wonyong, Seoul 06772 (KR); KANG, Donghun, Seoul 06772 (KR); YU, Hyosang, Seoul 06772 (KR); PARK, Hyungjo, Seoul 06772 (KR); SEONG, Junseok, Seoul 06772 (KR)
(74) Representative: Vossius & Partner Patentanwälte Rechtsanwälte mbB
(86) International application number: PCT/KR2024/012564
(87) International publication number: WO 2025/048402

(57) **Abstract**

The present disclosure is applicable to the technical field related to a display apparatus, and relates to, for example, a light emitting device, a manufacturing method thereof, and a display apparatus using the same. A light emitting device according to an embodiment of the present disclosure may include: a first conductivity type semiconductor layer; an active layer disposed on a first surface of the first conductivity type semiconductor layer; a second conductivity type semiconductor layer disposed on the active layer; a reflective layer disposed on a second surface of the first conductivity type semiconductor layer; and a light extraction layer disposed on the second conductivity type semiconductor layer, wherein the light extraction layer may include: a pillar structure including a plurality of unit pillars disposed on the second conductivity type semiconductor layer; and a first conductive layer locally disposed on the unit pillars.

## Description

### [Technical Field]

The present disclosure is applicable to the technical field related to a display apparatus, and for example, relates to a light emitting device, a method of manufacturing the same, and a display apparatus using the same.

### [Background Art]

Recently, in the field of display technology, display apparatuses having excellent characteristics such as thinness and flexibility are being developed. In contrast, major displays currently commercialized are represented by Liquid Crystal Displays (LCDs) and Organic Light Emitting Diodes (OLEDs).

However, the LCD has problems such as a slow response time and difficulty in implementing flexibility, and the OLED has problems such as a short lifespan and poor mass-production yield.

Meanwhile, a Light Emitting Diode (LED) is a semiconductor light emitting device well known for converting current into light. Starting with the commercialization of red LEDs using GaAsP compound semiconductors in 1962, they have been used as light sources for display images of electronic devices, including information communication equipment, together with GaP:N-based green LEDs. Accordingly, a method for solving the aforementioned problems may be proposed by implementing a display using a semiconductor light emitting device. The semiconductor light emitting device has various advantages such as a longer lifespan, lower power consumption, excellent initial driving characteristics, and high vibration resistance compared to filament-based light emitting devices.

A reflective film is used at the top or bottom of the light emitting device to improve light extraction efficiency and optical characteristics of such a light emitting device, but a rough surface (surface roughness) may be additionally formed on a light extraction surface to maximize the light extraction efficiency.

However, as the display apparatus becomes higher in definition, the size of the light emitting device used as a pixel decreases, and accordingly, the process of forming the rough surface (surface roughness) has a nanometer-scale pattern, making it increasingly difficult to use a general process.

In particular, as the size of the light emitting device is reduced to a micrometer unit, a phenomenon occurs in that a color viewing angle in left/right or up/down directions becomes non-uniform depending on a light extraction method and shape of the light emitting device.

Although this phenomenon can be partially improved through image quality compensation in a display apparatus or module, there is a problem in that a fundamental solution to the color viewing angle distortion is difficult.

Accordingly, a method for solving these problems is required.

### [Detailed Description of the Invention]

### [Technical Problem]

A technical problem to be solved by the present disclosure is to provide a light emitting device capable of improving light extraction efficiency of a light emitting device, a method of manufacturing the same, and a display apparatus using the same.

In addition, the present disclosure is to provide a light emitting device capable of efficiently implementing a light extraction structure of a light emitting device, a method of manufacturing the same, and a display apparatus using the same.

In addition, the present disclosure is to provide a light emitting device capable of improving the efficiency of a display apparatus together with the improvement of the light extraction efficiency of a light emitting device, a method of manufacturing the same, and a display apparatus using the same.

In addition, the present disclosure is to provide a light emitting device capable of improving a phenomenon in which a color viewing angle of a display apparatus becomes non-uniform depending on a light emitting device, a method of manufacturing the same, and a display apparatus using the same.

Furthermore, an object of an embodiment of the present invention is to solve various problems not mentioned herein. Those skilled in the art can understand through the entire intent of the specification and drawings.

### [Technical Solution]

A light emitting device according to an embodiment of the present disclosure for achieving the above object may include: a first conductivity type semiconductor layer; an active layer disposeddisposed on a first surface of the first conductivity type semiconductor layer; a second conductivity type semiconductor layer disposed on the active layer; a reflective layer disposed on a second surface of the first conductivity type semiconductor layer; and a light extraction layer disposed on the second conductivity type semiconductor layer, wherein the light extraction layer includes: a pillar structure including a plurality of unit pillars disposed on the first conductivity type semiconductor layer; and a first conductive layer locally disposed on the unit pillars.

A method of manufacturing a light emitting device according to an embodiment of the present disclosure for achieving the above object is a method of manufacturing a light emitting device including a semiconductor layer which includes a first conductivity type semiconductor layer, a second conductivity type semiconductor layer, a third conductivity type semiconductor layer, and an active layer disposed between the first conductivity type semiconductor layer and the second conductivity type semiconductor layer, the method comprising: forming a first conductive layer on the third conductivity type semiconductor layer; etching the first conductive layer; and etching the third conductivity type semiconductor layer using the first conductive layer as a mask to form a light extraction layer including a pillar structure including a plurality of unit pillars.

A display apparatus according to an embodiment of the present disclosure for achieving the above object is a display apparatus using a light emitting device, comprising: a wiring substrate on which first electrodes are arranged; a light emitting device including a semiconductor layer forming a unit sub-pixel, the light emitting device being disposed on the wiring substrate; a first connection electrode electrically connecting the first electrode and one side of the semiconductor layer of the light emitting device; a planarization layer covering the light emitting device and the first connection electrode; and a second connection electrode disposed on the planarization layer and electrically connecting with the other side of the semiconductor layer of the light emitting device, wherein the light emitting device includes a light extraction layer disposed on the semiconductor layer, wherein the light extraction layer includes: a pillar structure including a plurality of unit pillars disposed on the semiconductor layer; and a first conductive layer locally disposed on the unit pillars.

### [Advantageous Effects]

According to an embodiment of the present disclosure, the following effects are provided.

First, a light extraction structure of a light emitting device can be efficiently implemented, so that light extraction efficiency of the light emitting device can be improved.

In addition, the efficiency of a display apparatus can be improved together with the improvement of the light extraction efficiency of a light emitting device.

In addition, a phenomenon in which a color viewing angle of a display apparatus becomes non-uniform depending on a light emitting device can be improved.

Furthermore, according to another embodiment of the present disclosure, there are additional technical effects not mentioned herein. Those skilled in the art can understand through the entire intent of the specification and drawings.

### [Description of Drawings]

FIG. 1 is an exemplary view of a living room of a house in which a display apparatus according to an embodiment is disposed.
FIG. 2 is a block diagram schematically showing a display apparatus according to an embodiment.
FIG. 3 is a circuit diagram showing an example of a pixel of FIG. 2. [
FIG. 4 is an enlarged view of a first panel region in the display apparatus of FIG. 1.
FIG. 5 is a cross-sectional view taken along line B1-B2 of region A2 of FIG. 4.
FIG. 6 is an exemplary view showing a light emitting device according to an embodiment being assembled to a substrate by a self-assembly method.
FIG. 7 is a cross-sectional view showing a light emitting device according to a first embodiment of the present disclosure.
FIG. 8 is a partially enlarged cross-sectional view of a light emitting device according to embodiments of the present disclosure.
FIG. 9 is a photograph of a portion of FIG. 8.
FIG. 10 is a partially enlarged cross-sectional view of a light emitting device according to a modified embodiment of the present disclosure.
FIG. 11 and FIG. 12 are cross-sectional views for explaining a manufacturing process of a light emitting device according to an embodiment of the present disclosure.
FIG. 13 to FIG. 18 are photographs showing a manufacturing process of a light emitting device according to an embodiment of the present disclosure.
FIG. 19 and FIG. 20 are photographs showing changes according to an increase in etching time of a first conductive layer.
FIG. 21 to FIG. 23 are photographs showing changes according to an increase in etching time of a third conductivity type semiconductor layer.
FIG. 24 is a cross-sectional view showing a light emitting device according to a second embodiment of the present disclosure.
FIG. 25 is a cross-sectional view showing a light emitting device according to a third embodiment of the present disclosure.
FIG. 26 is a cross-sectional view showing a display apparatus according to an embodiment of the present disclosure.
FIG. 27 is a cross-sectional view showing a display apparatus according to another embodiment of the present disclosure.

### [Best Mode]

Hereinafter, embodiments disclosed in the present specification will be described in detail with reference to the accompanying drawings. The same or similar components may be assigned the same reference numerals regardless of the reference numerals used in the drawings, and redundant descriptions thereof may be omitted. Suffixes such as "module" and "unit" used for constituent elements in the following description are assigned or used interchangeably merely for convenience of drafting and do not have mutually distinct meanings or roles by themselves. In describing the embodiments disclosed herein, if a detailed description of related well-known technology is determined to unnecessarily obscure the gist of the disclosed embodiments, such detailed description may be omitted. It should also be noted that the accompanying drawings are provided only to facilitate understanding of the disclosed embodiments and should not be construed as limiting the technical spirit disclosed herein.

For convenience of description, each drawing is described separately; however, it will be understood by those skilled in the art that combining at least two drawings to implement another embodiment may fall within the scope of the present disclosure.

When an element such as a layer, region, or substrate is referred to as being "on" another element, it may be directly on the other element or one or more intervening elements may be present therebetween.

The display apparatus described herein refers to any display apparatus that displays information using a unit pixel or a set of unit pixels. Accordingly, the concept is not limited to a finished product and may also be applied to components. For example, a panel corresponding to a component of a digital TV may independently correspond to the display apparatus described herein. Finished products may include, for example, mobile phones, smart phones, laptop computers, digital broadcasting terminals, personal digital assistants (PDAs), portable multimedia players (PMPs), navigation devices, slate PCs, tablet PCs, ultrabooks, digital TVs, and desktop computers.

A person skilled in the art will readily appreciate that the configuration according to the embodiments described herein may also be applied to devices capable of displaying images, even if such devices take the form of products developed in the future.

The semiconductor light emitting device referred to in the present specification encompasses LEDs, micro-LEDs, and the like, and these terms may be used interchangeably.

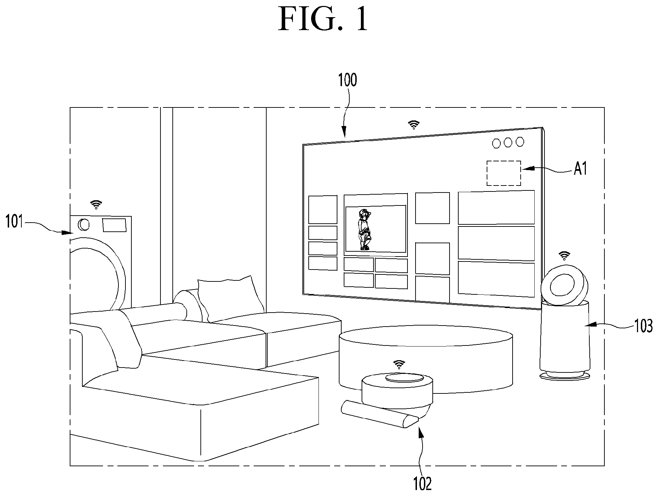

FIG. 1 illustrates a living room of a house in which a display apparatus according to an embodiment is arranged.

A display apparatus 100 according to an embodiment may display states of various electronic products such as a washing machine 101, a robot cleaner 102, and an air purifier 103, may communicate with the respective electronic products based on loT, and may control the respective electronic products based on user setting data.

The display apparatus 100 according to an embodiment may include a flexible display fabricated on a thin and flexible substrate. The flexible display may maintain characteristics of a conventional flat panel display while being bendable or rollable like paper.

In the flexible display, visual information may be implemented by independently controlling light emission of unit pixels arranged in a matrix form. A unit pixel refers to a minimum unit for implementing one color. The unit pixel of the flexible display may be implemented by a light emitting device. In an embodiment, the light emitting device may be a micro-LED or a nano-LED, but is not limited thereto.

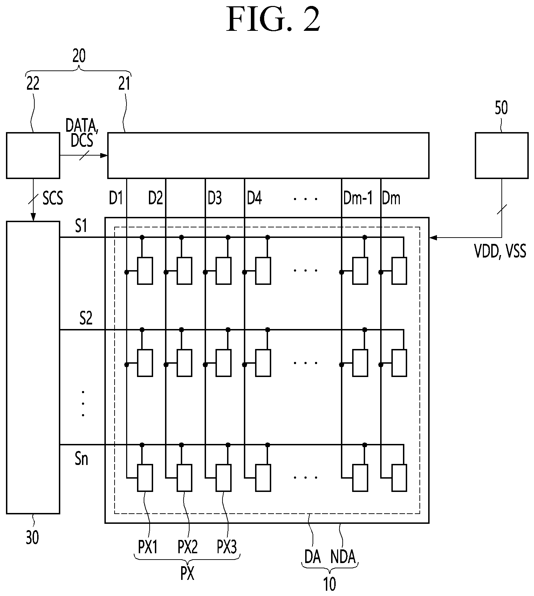

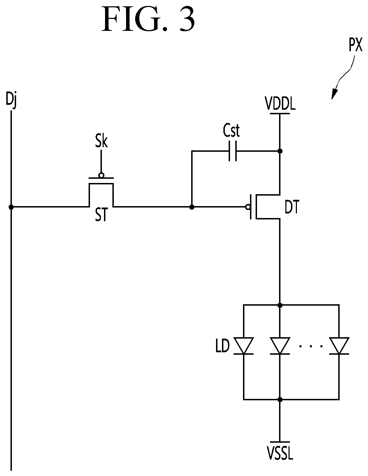

FIG. 2 is a block diagram schematically illustrating a display apparatus according to an embodiment, and FIG. 3 is a circuit diagram illustrating an example of a pixel of FIG. 2.

Referring to FIGS. 2 and 3, the display apparatus according to an embodiment may include a display panel 10, a driving circuit 20, a scan driver 30, and a power supply circuit 50.

The display apparatus 100 according to an embodiment may drive the light emitting devices in an active matrix (AM) scheme or a passive matrix (PM) scheme.

The driving circuit 20 may include a data driver 21 and a timing controller 22.

The display panel 10 may be divided into a display area DA and a non-display area NDA disposed around the display area DA. The display area DA is an area in which pixels PX are formed to display an image. The display panel 10 may include data lines D1 to Dm (where m is an integer of 2 or greater), scan lines S1 to Sn (where n is an integer of 2 or greater) crossing the data lines D1 to Dm, a high-potential voltage line to which a high-potential voltage is supplied, a low-potential voltage line to which a low-potential voltage is supplied, and pixels PX connected to the data lines D1 to Dm and the scan lines S1 to Sn.

Each of the pixels PX may include a first sub-pixel PX1, a second sub-pixel PX2, and a third sub-pixel PX3. The first sub-pixel PX1 may emit first color light having a first wavelength, the second sub-pixel PX2 may emit second color light having a second wavelength, and the third sub-pixel PX3 may emit third color light having a third wavelength. The first color light may be red light, the second color light may be green light, and the third color light may be blue light, but is not limited thereto. Although FIG. 2 illustrates that each pixel PX includes three sub-pixels, the disclosure is not limited thereto. Each pixel PX may include four or more sub-pixels.

Each of the first sub-pixel PX1, the second sub-pixel PX2, and the third sub-pixel PX3 may be connected to at least one of the data lines D1 to Dm, at least one of the scan lines S1 to Sn, and the high-potential voltage line. As illustrated in FIG. 3, the first sub-pixel PX1 may include light emitting devices LD, a plurality of transistors for supplying current to the light emitting devices LD, and at least one capacitor Cst.

Although not illustrated in the drawings, each of the first sub-pixel PX1, the second sub-pixel PX2, and the third sub-pixel PX3 may include only one light emitting device LD and at least one capacitor Cst.

Each of the light emitting devices LD may be a semiconductor light emitting diode including a first electrode, a plurality of conductivity type semiconductor layers, and a second electrode. Here, the first electrode may be an anode electrode and the second electrode may be a cathode electrode, but is not limited thereto.

Referring to FIG. 3, the plurality of transistors may include a driving transistor DT that supplies current to the light emitting devices LD and a scan transistor ST that supplies a data voltage to a gate electrode of the driving transistor DT. The driving transistor DT may include a gate electrode connected to a source electrode of the scan transistor ST, a source electrode connected to the high-potential voltage line to which a high-potential voltage is applied, and a drain electrode connected to the first electrodes of the light emitting devices LD. The scan transistor ST may include a gate electrode connected to a scan line Sk (where k is an integer satisfying 1≤k≤n), a source electrode connected to the gate electrode of the driving transistor DT, and a drain electrode connected to a data line Dj (where j is an integer satisfying 1≤j≤m).

The capacitor Cst may be formed between the gate electrode and the source electrode of the driving transistor DT. The storage capacitor Cst can charge a difference value between a gate voltage and a source voltage of the driving transistor DT.

The driving transistor DT and the scan transistor ST may be formed as thin film transistors. In FIG. 3, the driving transistor DT and the scan transistor ST are described mainly as being formed as P-type MOSFETs (metal oxide semiconductor field effect transistors), but the present disclosure is not limited thereto. The driving transistor DT and the scan transistor ST may be formed as N-type MOSFETs. In this case, positions of the source electrode and the drain electrode of each of the driving transistor DT and the scan transistor ST may be changed.

In FIG. 3, each of the first sub-pixel PX1, the second sub-pixel PX2, and the third sub-pixel PX3 is illustrated as including a 2T1C (two transistors and one capacitor) configuration having one driving transistor DT, one scan transistor ST, and one capacitor Cst; however, the present disclosure is not limited thereto. Each of the first sub-pixel PX1, the second sub-pixel PX2, and the third sub-pixel PX3 may include a plurality of scan transistors ST and a plurality of capacitors Cst.

Referring again to FIG. 2, the driving circuit 20 outputs signals and voltages for driving the display panel 10. To this end, the driving circuit 20 may include the data driver 21 and the timing controller 22.

The data driver 21 receives digital video data DATA and a source control signal DCS from the timing controller 22. The data driver 21 converts the digital video data DATA into analog data voltages according to the source control signal DCS and supplies the analog data voltages to the data lines D1 to Dm of the display panel 10.

The timing controller 22 receives the digital video data DATA and timing signals from a host system. The timing signals may include a vertical sync signal, a horizontal sync signal, a data enable signal, and a dot clock. The host system may be, for example, an application processor of a smart phone or a tablet PC, a monitor controller, or a system-on-chip of a TV.

The scan driver 30 receives a scan control signal SCS from the timing controller 22. The scan driver 30 generates scan signals according to the scan control signal SCS and supplies the scan signals to the scan lines S1 to Sn of the display panel 10. The scan driver 30 may include a plurality of transistors and may be formed in the non-display area NDA of the display panel 10. Alternatively, the scan driver 30 may be formed as an integrated circuit, and in this case may be mounted on a gate flexible film attached to another side of the display panel 10.

The power supply circuit 50 may generate a high-potential voltage VDD and a low-potential voltage VSS for driving the light emitting devices LD of the display panel 10 from a main power source and may supply the generated voltages to the high-potential voltage line and the low-potential voltage line of the display panel 10. The power supply circuit 50 may also generate driving voltages for driving the driving circuit 20 and the scan driver 30 from the main power source and supply the generated driving voltages thereto.

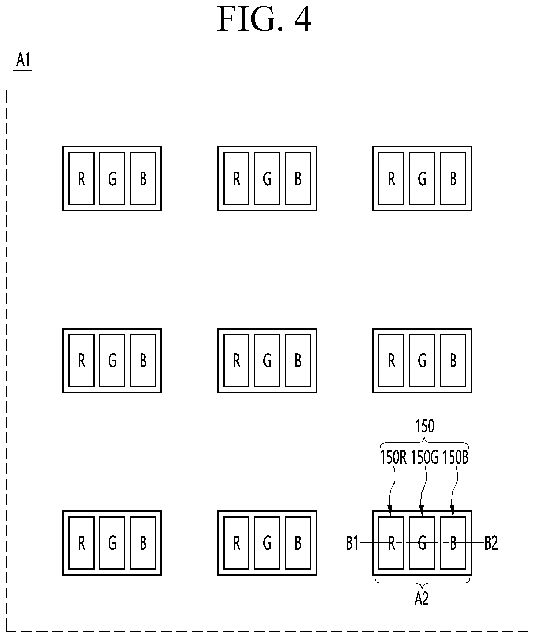

FIG. 4 is an enlarged view of a first panel area of the display apparatus of FIG. 1.

Referring to FIG. 4, the display apparatus 100 according to an embodiment may be manufactured by mechanically and electrically connecting a plurality of panel areas, such as the first panel area A1, through tiling.

The first panel area A1 may include a plurality of light emitting devices 150 arranged for each unit pixel (PX of FIG. 2).

For example, the unit pixel PX may include a first sub-pixel PX1, a second sub-pixel PX2, and a third sub-pixel PX3. A plurality of red light emitting devices 150R may be arranged in the first sub-pixel PX1, a plurality of green light emitting devices 150G may be arranged in the second sub-pixel PX2, and a plurality of blue light emitting devices 150B may be arranged in the third sub-pixel PX3. The unit pixel PX may further include a fourth sub-pixel in which no light emitting device is arranged, but is not limited thereto. The light emitting device 150 may be a semiconductor light emitting device.

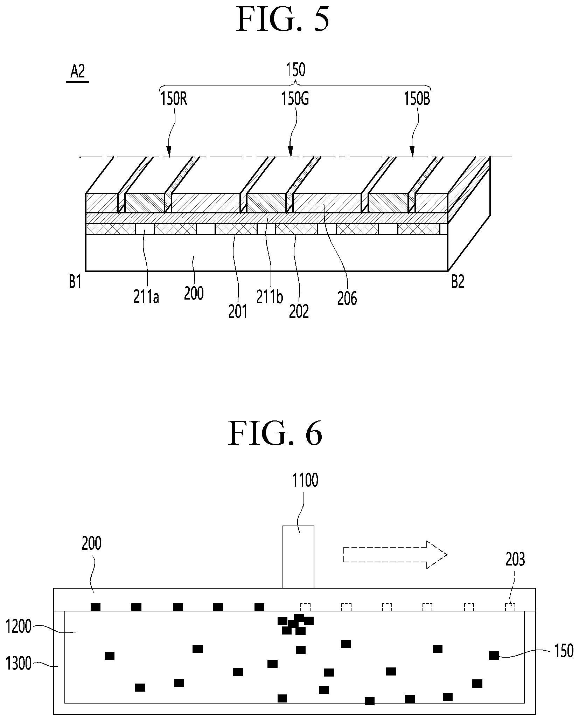

FIG. 5 is a cross-sectional view taken along line B1-B2 of area A2 in FIG. 4.

Referring to FIG. 5, the display apparatus 100 according to an embodiment may include a substrate 200, assembly wirings 201 and 202, a first insulating layer 211a, a second insulating layer 211b, a third insulating layer 206, and a plurality of light emitting devices 150.

The assembly wirings may include a first assembly wiring 201 and a second assembly wiring 202 spaced apart from each other. The first assembly wiring 201 and the second assembly wiring 202 may be provided to generate a dielectrophoretic force for assembling the light emitting device 150. The first assembly wiring 201 and the second assembly wiring 202 may also be electrically connected to electrodes of the light emitting device and may function as electrodes of the display panel.

The assembly wirings 201 and 202 may be formed of a transparent electrode such as ITO or may include a metal material having excellent electrical conductivity. For example, the assembly wirings 201 and 202 may be formed of at least one selected from titanium (Ti), chromium (Cr), nickel (Ni), aluminum (Al), platinum (Pt), gold (Au), tungsten (W), molybdenum (Mo), and alloys thereof.

The first insulating layer 211a may be disposed between the first assembly wiring 201 and the second assembly wiring 202, and the second insulating layer 211b may be disposed on the first assembly wiring 201 and the second assembly wiring 202. The first insulating layer 211a and the second insulating layer 211b may be an oxide layer, a nitride layer, or the like, but are not limited thereto.

The light emitting devices 150 may include a red light emitting device 150R, a green light emitting device 150G, and a blue light emitting device 150B to constitute respective unit sub-pixels, but are not limited thereto. Alternatively, red and green colors may be implemented using a red phosphor and a green phosphor.

The substrate 200 may be formed of glass or polyimide. The substrate 200 may also include a flexible material such as polyethylene naphthalate (PEN) or polyethylene terephthalate (PET). The substrate 200 may be formed of a transparent material, but is not limited thereto.

The third insulating layer 206 may include an insulating and flexible material such as polyimide, PEN, or PET, and may be integrally formed with the substrate 200 to constitute a single substrate.

The third insulating layer 206 may be a conductive adhesive layer having adhesiveness and conductivity. The conductive adhesive layer may have ductility and may enable a flexible function of the display apparatus. For example, the third insulating layer 206 may be an anisotropic conductive film (ACF), an anisotropic conductive medium, or a conductive adhesive layer such as a solution containing conductive particles. The conductive adhesive layer may be electrically conductive in a vertical direction with respect to its thickness and electrically insulating in a horizontal direction with respect to its thickness.

The third insulating layer 206 may include assembly holes 203 into which the light emitting devices 150 are inserted (see FIG. 6). Accordingly, during self-assembly, the light emitting devices 150 may be easily inserted into the assembly holes 203 of the third insulating layer 206. The assembly holes 203 may also be referred to as insertion holes, fixing holes, or alignment holes.

A spacing between the assembly wirings 201 and 202 may be formed smaller than a width of the light emitting device 150 and a width of the assembly hole 203, such that an assembly position of the light emitting device 150 using an electric field may be more precisely fixed.

The third insulating layer 206 may be formed on the assembly wirings 201 and 202 to protect the assembly wirings 201 and 202 from a fluid 1200 and to prevent leakage of current flowing through the assembly wirings 201 and 202. The third insulating layer 206 may be formed as a single layer or multiple layers of an inorganic insulator such as silica or alumina, or an organic insulator.

The third insulating layer 206 may include an insulating and flexible material such as polyimide, PEN, or PET, and may be integrally formed with the substrate 200 to constitute a single substrate.

The third insulating layer 206 may be an adhesive insulating layer or a conductive adhesive layer having conductivity. The third insulating layer 206 may have ductility and may enable a flexible function of the display apparatus.

The third insulating layer 206 may have a partition wall, and the assembly hole 203 may be formed by the partition wall. For example, when forming the substrate 200, a portion of the third insulating layer 206 may be removed, such that each of the light emitting devices 150 may be assembled into the assembly hole 203 of the third insulating layer 206.

The substrate 200 may include assembly holes 203 to which the light emitting devices 150 are coupled, and a surface on which the assembly holes 203 are formed may be in contact with the fluid 1200. The assembly holes 203 may guide accurate assembly positions of the light emitting devices 150.

The assembly hole 203 may have a shape and size corresponding to a shape of the light emitting device 150 to be assembled at a corresponding position. Accordingly, assembling a different light emitting device or assembling a plurality of light emitting devices in a single assembly hole 203 may be prevented.

FIG. 6 illustrates an example in which the light emitting devices according to an embodiment are assembled onto a substrate by a self-assembly method. The self-assembly method of the light emitting devices will be described with reference to FIG. 6.

The substrate 200 may be a panel substrate of a display apparatus. In the following description, the substrate 200 is described as a panel substrate of a display apparatus, but embodiments are not limited thereto.

Referring to FIG. 6, a plurality of light emitting devices 150 may be introduced into a chamber 1300 filled with a fluid 1200. The fluid 1200 may be water such as deionized water, but is not limited thereto. The chamber 1300 may be referred to as a water tank, container, or vessel.

Thereafter, the substrate 200 may be disposed on the chamber 1300. According to an embodiment, the substrate 200 may be inserted into the chamber 1300.

As illustrated in FIG. 5, a pair of assembly wirings 201 and 202 corresponding to each light emitting device 150 to be assembled may be disposed on the substrate 200.

Referring to FIG. 6, after the substrate 200 is disposed, an assembly apparatus 1100 including a magnetic material may move along the substrate 200. As the magnetic material, for example, a magnet or an electromagnet may be used. The assembly apparatus 1100 may move while being in contact with the substrate 200 in order to maximize a region to which a magnetic field is applied within the fluid 1200.

According to an embodiment, the assembly apparatus 1100 may include a plurality of magnetic materials or may include a magnetic material having a size corresponding to that of the substrate 200. In this case, a movement distance of the assembly apparatus 1100 may be limited within a predetermined range.

By the magnetic field generated by the assembly apparatus 1100, the light emitting devices 150 in the chamber 1300 may move toward the assembly apparatus 1100.

While moving toward the assembly apparatus 1100, the light emitting device 150 may enter the assembly hole 203 by a dielectrophoretic (DEP) force and may come into contact with the substrate 200.

Specifically, the assembly wirings 201 and 202 may form an electric field by power supplied from the outside, and a dielectrophoretic force may be generated between the assembly wirings 201 and 202 by the electric field. By the dielectrophoretic force, the light emitting device 150 may be fixed in the assembly hole 203 on the substrate 200.

By the electric field applied by the assembly wirings 201 and 202 formed on the substrate 200, separation of the light emitting device 150, which is in contact with the substrate 200, due to movement of the assembly apparatus 1100 may be prevented. According to an embodiment, by the above-described self-assembly method using an electromagnetic field, the time required to assemble each of the light emitting devices 150 onto the substrate 200 can be drastically reduced, thereby enabling a large-area, high-resolution display to be implemented more rapidly and economically.

In this case, a predetermined solder layer (not shown) may be formed between the light emitting device 150 assembled in the assembly hole 203 of the substrate 200 and an assembly electrode, thereby improving bonding strength of the light emitting device 150.

Thereafter, a molding layer (not shown) may be formed in the assembly hole 203 of the substrate 200. The molding layer may be a transparent resin or a resin including a reflective material or a scattering material.

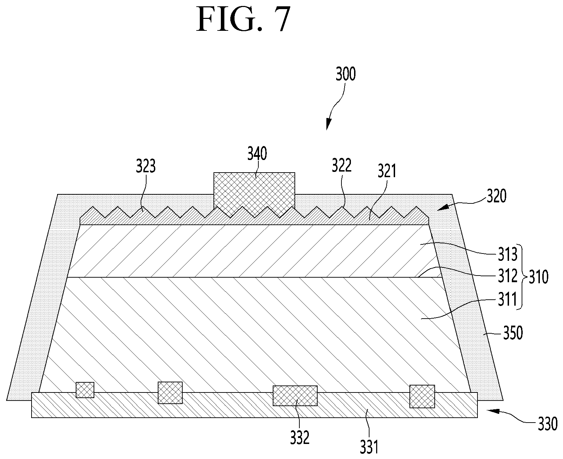

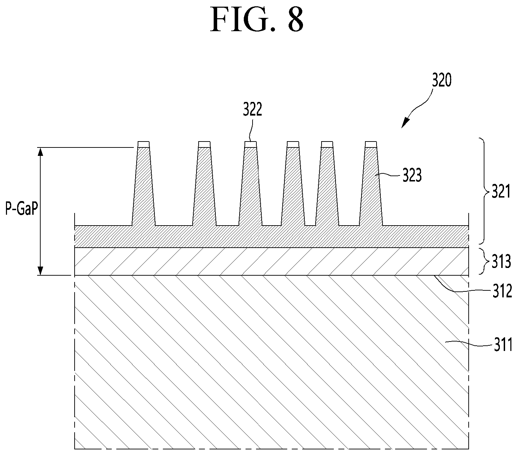

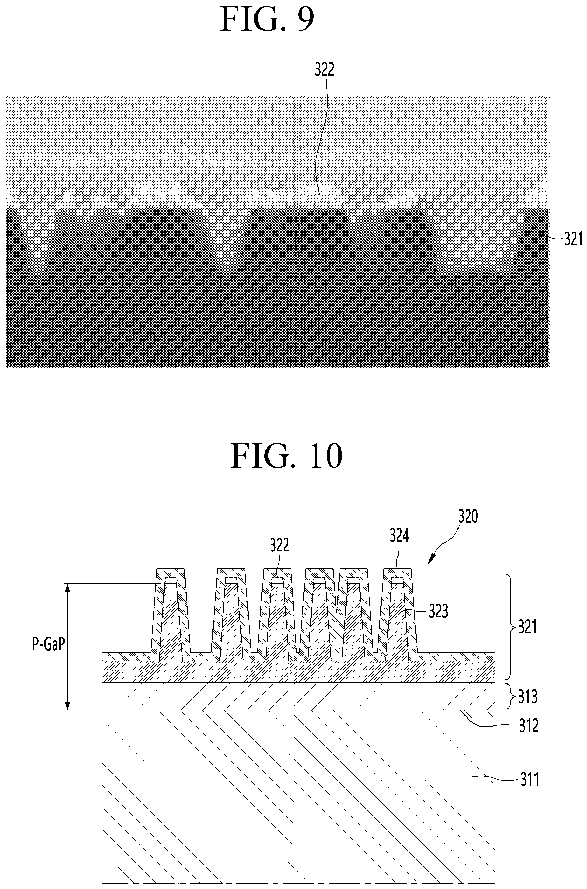

FIG. 7 is a cross-sectional view illustrating a light emitting device according to a first embodiment of the present disclosure. FIG. 8 is a partially enlarged cross-sectional view of a light emitting device according to embodiments of the present disclosure. FIG. 9 is a photograph of a portion of FIG. 8. FIG. 10 is a partially enlarged cross-sectional view of a light emitting device according to a modified embodiment of the present disclosure.

Referring to FIG. 7, a light emitting device 300 according to the present embodiment may include a semiconductor layer 310 including a first conductivity type semiconductor layer 311, a second conductivity type semiconductor layer 313, and an active layer 312 disposed between the first conductivity type semiconductor layer 311 and the second conductivity type semiconductor layer 313. For example, the semiconductor layer 310 may include the first conductivity type semiconductor layer 311, the active layer 312 disposed on a first surface of the first conductivity type semiconductor layer 311, and the second conductivity type semiconductor layer 313 disposed on the active layer 312. A horizontal cross-sectional shape of the semiconductor layer 310 may be one of a circular shape, an elliptical shape, or a polygonal shape. The light emitting device 300 according to this first embodiment may have a vertical structure.

For example, the first conductivity type may be n-type. Accordingly, the second conductivity type may be p-type. Hereinafter, embodiments of the present disclosure will be mainly described with reference to an example in which the first conductivity type is n-type and the second conductivity type is p-type. For example, the first conductivity type semiconductor layer 311 may be an n-type semiconductor layer and the second conductivity type semiconductor layer 313 may be a p-type semiconductor layer. However, embodiments of the present disclosure are not limited thereto. In another example, the first conductivity type semiconductor layer 311 may be a p-type semiconductor layer and the second conductivity type semiconductor layer 313 may be an n-type semiconductor layer.

As an illustrative embodiment, the light emitting device may be a red light emitting device for emitting red light. The red light emitting device may include a GaP-, GaAs-, or InP-based semiconductor. For example, the red light emitting device may include a compound semiconductor material composed of at least one combination of In, Ga, As, and P. However, embodiments of the present disclosure are not limited thereto.

A light extraction layer 320 may be disposed on the second conductivity type semiconductor layer 313. The light extraction layer 320 can improve extraction efficiency of light generated in the semiconductor layer 310. Specifically, light generated in the active layer 312 of the semiconductor layer 310 can be efficiently emitted to an outside of the light emitting device 300 by the action of the light extraction layer 320.

Referring to FIGS. 7 to 9, the light extraction layer 320 may include a pillar structure 321 including a plurality of unit pillars 323 disposed on the second conductivity type semiconductor layer 313. The light extraction layer 320 may further include a first conductive layer 322 locally disposed on the unit pillars 323.

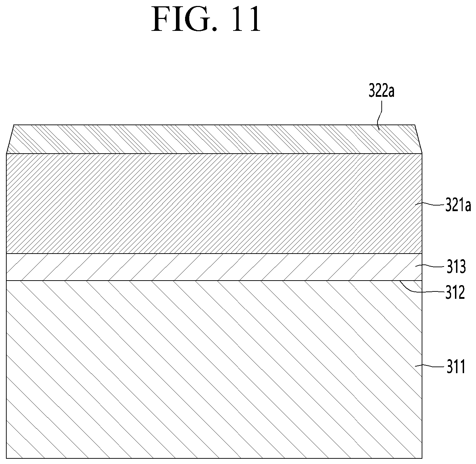

The pillar structure 321 may include a third conductivity type semiconductor. For example, the pillar structure 321 may be formed by etching a third conductivity type semiconductor layer 321a (see FIG. 11). For example, the third conductivity type semiconductor or the third conductivity type semiconductor layer 321a may include the same semiconductor material as the second conductivity type semiconductor layer 313. In this case, the third conductivity type semiconductor or the third conductivity type semiconductor layer 321a may have a higher doping concentration than that of the second conductivity type semiconductor layer 313.

The first conductive layer 322 may be locally disposed at an end of each unit pillar 323. For example, the first conductive layer 322 may have a size equal to or smaller than that of the corresponding unit pillar 323. Referring to FIG. 8, the first conductive layer 322 may be partially disposed on an upper end of the unit pillar 323.

As an illustrative embodiment, the first conductive layer 322 may include a transparent conductive oxide. For example, the first conductive layer 322 may include a conductive oxide material such as indium tin oxide (ITO). However, the present disclosure is not limited thereto, and various conductive oxide materials such as ZnO, SnO, or MgO may be used.

FIG. 9 shows a focused ion beam (FIB) image illustrating a state in which the first conductive layer 322 is disposed at an end of the pillar structure 321 having the structure shown in FIG. 8.

The first conductive layer 322 may function as a contact layer (second contact layer) on the semiconductor layer 310. For example, the first conductive layer 322 may function as a contact layer for the second conductivity type semiconductor layer 313.

As an illustrative embodiment, referring to FIG. 10, a second conductive layer 324 may be further disposed on the first conductive layer 322. For example, the second conductive layer 324 may include a transparent conductive oxide. For example, the second conductive layer 324 may include a conductive oxide material such as indium tin oxide (ITO).

The second conductive layer 324 may include the same material as the first conductive layer 322. For example, the second conductive layer 324 may be formed of the same material as the first conductive layer 322. The second conductive layer 324, together with the first conductive layer 322, may function as a contact layer (second contact layer) on the semiconductor layer 310.

As an illustrative embodiment, the second conductive layer 324 may be further disposed on the pillar structure 321. For example, the second conductive layer 324 may have a structure that covers the first conductive layer 322 and an upper surface of the pillar structure 321. For example, the second conductive layer 324 may cover most of an upper surface of the light extraction layer 320. In another example, the second conductive layer 324 may cover an entire upper surface of the light extraction layer 320.

The pillar structure 321 may be a structure etched using the first conductive layer 322 as a mask. For example, the first conductive layer 322 disposed on the semiconductor layer may function as an etching mask to form the pillar structure 321. Details thereof will be described below.

Referring to FIGS. 8 and 10, the second conductivity type semiconductor layer 313 and the pillar structure 321 may be formed as p-type semiconductor layers. For example, the second conductivity type semiconductor layer 313 and the pillar structure 321 may include p-type GaP.

As a specific example, the second conductivity type semiconductor layer 313 may include an Mg-doped p-GaP layer. The pillar structure 321 may have a higher doping concentration than that of the second conductivity type semiconductor layer 313. For example, the pillar structure 321 may include a heavily doped p-GaP layer doped with C.

Referring again to FIG. 7, the light emitting device 300 according to an embodiment of the present disclosure may include a reflective layer 331 disposed on a second surface (a lower surface in FIG. 7) of the first conductivity type semiconductor layer 311.

The reflective layer 331 may include Au (gold) and Ag (silver). For example, the reflective layer 331 may include an AgAu alloy.

The light emitting device 300 may further include a first contact layer 332, at least a portion of which is discontinuously and electrically connected to the second surface of the first conductivity type semiconductor layer 311.

Accordingly, the light emitting device 300 may include a metal structure 330 including the reflective layer 331 and the first contact layer 332 on the second surface (lower surface in FIG. 7) of the first conductivity type semiconductor layer 311.

The first contact layer 332 may be at least partially electrically connected to the first conductivity type semiconductor layer 311. Here, the term "discontinuously" or "at least partially" may mean that the first contact layer 332 is in discontinuous contact with at least a portion of the lower surface (second surface) of the first conductivity type semiconductor layer 311, which faces the reflective layer 331.

For example, the first contact layer 332 may be disposed to partially form an ohmic contact with the first conductivity type semiconductor layer 311 without covering the entire lower surface (second surface) of the first conductivity type semiconductor layer 311. In this case, the reflective layer 331 may be disposed on a portion of the lower surface of the first conductivity type semiconductor layer 311 where the first contact layer 332 is not disposed, such that reflectivity of the light emitting device 300 may be maintained without being significantly reduced by the first contact layer 332.

As an illustrative embodiment, the first contact layer 332 may occupy 5% to 20% of a total area of the lower surface (second surface) of the first conductivity type semiconductor layer 311.

A portion of the first contact layer 332 forming the ohmic contact with the first conductivity type semiconductor layer 311 may include a region in which at least a part of the first contact layer 332 is diffused into the first conductivity type semiconductor layer 311.

As an illustrative embodiment, the first contact layer 332 may include a first metal forming an ohmic contact with the first conductivity type semiconductor layer 311 and a second metal for diffusing the first metal. For example, the first metal and the second metal may form an alloy.

Accordingly, the first metal constituting the first contact layer 332 may include a region diffused into the first conductivity type semiconductor layer 311 (a diffusion region).

For example, the first metal may include Ge, and the second metal may include Au. For example, the first contact layer 332 may include an alloy of gold (Au) and germanium (Ge). That is, the first contact layer 332 may include an AuGe material.

Here, Ge may be diffused into the first conductivity type semiconductor layer 311 to form an ohmic contact with the first conductivity type semiconductor layer 311. Au may help Ge to be uniformly distributed on the second surface without agglomeration.

As an illustrative embodiment, an interface may exist between the first contact layer 332 and the reflective layer 331. For example, the first contact layer 332 and the reflective layer 331 may exist as separate layers without forming an alloy.

Accordingly, the first contact layer 332 may be disposed in a relatively inner region of the lower surface of the first conductivity type semiconductor layer 311, and the reflective layer 331 may be disposed in a relatively outer region thereof.

As an illustrative embodiment, although not separately illustrated, the metal structure 330 of the light emitting device 300 according to an embodiment of the present disclosure may further include a magnetic layer.

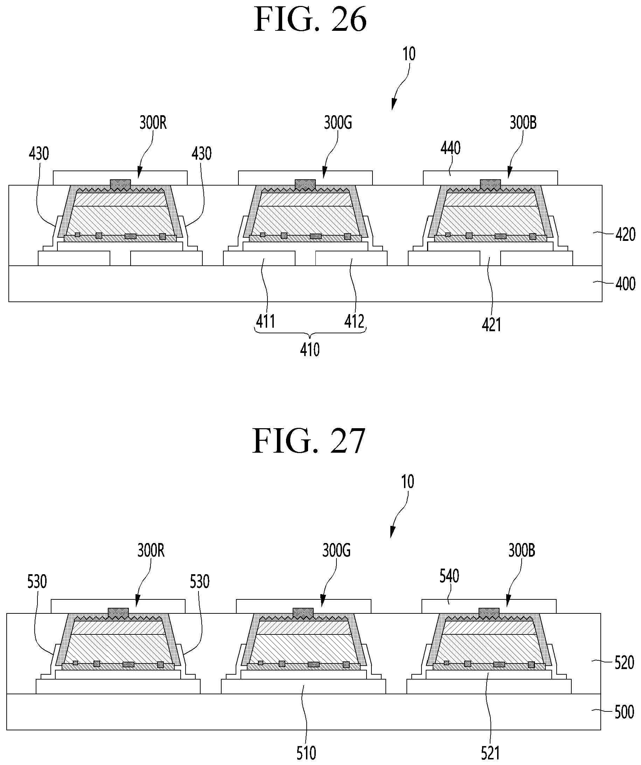

In order to be used as a sub-pixel of a display apparatus, the light emitting device 300 may be assembled onto a wiring substrate 500 (see FIG. 27) or onto a wiring substrate 400 (see FIG. 26) serving as an assembly substrate, using magnetic force. For example, the light emitting device 300 may be assembled on a fluid using magnetic force. Accordingly, the magnetic layer may assist in an assembly process of the light emitting device 300 according to magnetic force. Detailed description thereof is omitted.

As described above, the first conductive layer 322 or the first contact layer 332, together with the second conductive layer 324, may function as a second contact layer. An electrode pad 340 may be provided on the second contact layer.

The light emitting device 300 may include a passivation layer 350 that protects side surfaces of the semiconductor layer 310 and the light extraction layer 320.

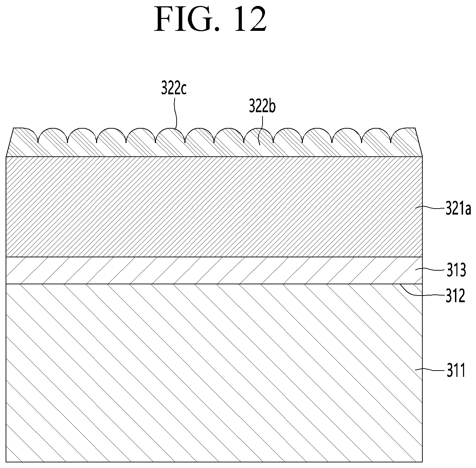

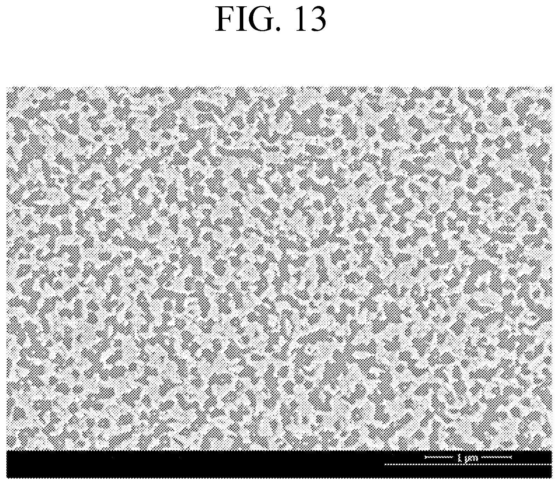

FIGS. 11 and 12 are cross-sectional views for explaining a manufacturing process of a light emitting device according to an embodiment of the present disclosure. FIGS. 13 to 18 are photographs illustrating a manufacturing process of a light emitting device according to an embodiment of the present disclosure.

FIGS. 11 and 12 mainly illustrate a process of forming the light extraction layer 320 on the semiconductor layer 310 (see FIG. 7) of the light emitting device 300. Referring to FIGS. 12 and 13, a manufacturing process of a light emitting device including a semiconductor layer 310 including a first conductivity type semiconductor layer 311, a second conductivity type semiconductor layer 313, a third conductivity type semiconductor layer 321a, and an active layer 312 disposed between the first conductivity type semiconductor layer 311 and the second conductivity type semiconductor layer 313 is illustrated.

First, referring to FIG. 11, a planarized first conductive layer 322a may be formed on the third conductivity type semiconductor layer 321a. The first conductive layer 322a may be formed to a thickness of several tens to several hundreds of nanometers on the third conductivity type semiconductor layer 321a. As an illustrative embodiment, the first conductive layer 322a may be ITO. The ITO may be formed by an e-beam deposition method or a sputter deposition method. When ITO is formed by sputter deposition, an additional crystallization process may be required. Through such crystallization, an etch selectivity with respect to the third conductivity type semiconductor layer 321a may be improved.

Thereafter, referring to FIG. 12, the planarized first conductive layer 322a may be etched to form a mask layer 322b. The mask layer 322b may include a random mask 322c having a grain shape. For example, the first conductive layer 322a may be wet-etched to form the mask layer 322b including the random mask 322c.

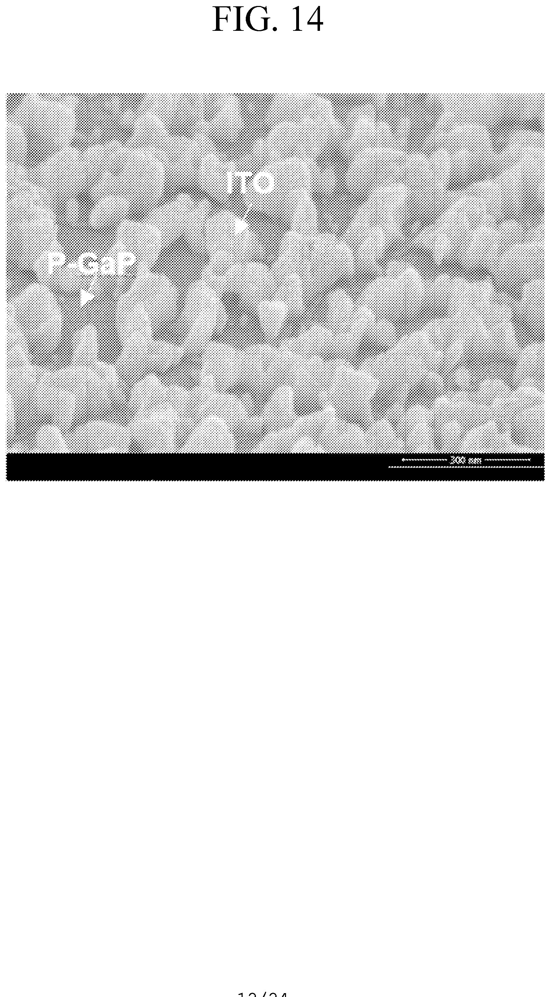

FIGS. 13 and 14 are scanning electron microscope (SEM) images illustrating a state in which the mask layer 322b (ITO) is formed on the third conductivity type semiconductor layer 321a (P-GaP). FIG. 13 shows a plan view of the etched surface, and FIG. 14 shows a perspective view of the etched surface observed at an oblique angle.

As an etchant used in the wet etching process, hydrochloric acid, nitric acid, oxalic acid, iron chloride-based reagents, TE-100, or a mixture thereof may be used. It is also possible to increase the temperature of the solution during use.

Next, the third conductivity type semiconductor layer 321a may be etched using the mask layer 322b. In this manner, the third conductivity type semiconductor layer 321a may be etched using the etched first conductive layer 322c as a mask to form the light extraction layer 320 (see FIG. 7). The light extraction layer 320 may include the pillar structure 321 including a plurality of unit pillars 323. Redundant description of the light extraction layer 320 will be omitted.

The third conductivity type semiconductor layer 321a may be dry-etched to form the pillar structure 321 including the plurality of unit pillars 323.

The dry etching may be performed to a desired depth using a single plasma or mixed plasma of CF₄, Ar, BCl₃, SiCl₄, O₂, or the like. In order to achieve a low operating voltage and improved current spreading, a portion of the thickness of the third conductivity type semiconductor layer 321a may be maintained in a planarized state.

The etch depth may be 40 nm or more, which may correspond to a minimum depth contributing to the light extraction layer 320. The maximum etch depth may be less than a maximum thickness of the third conductivity type semiconductor layer 321a.

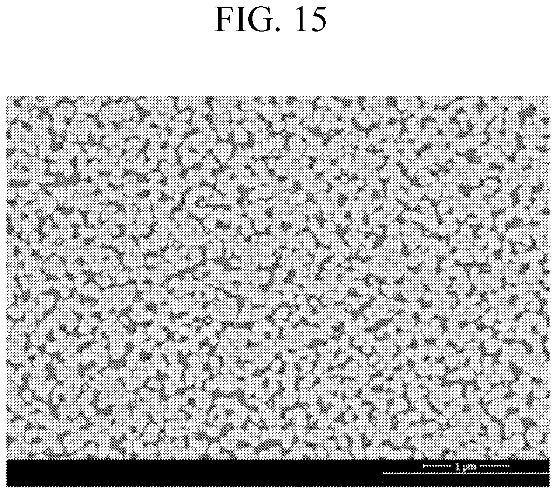

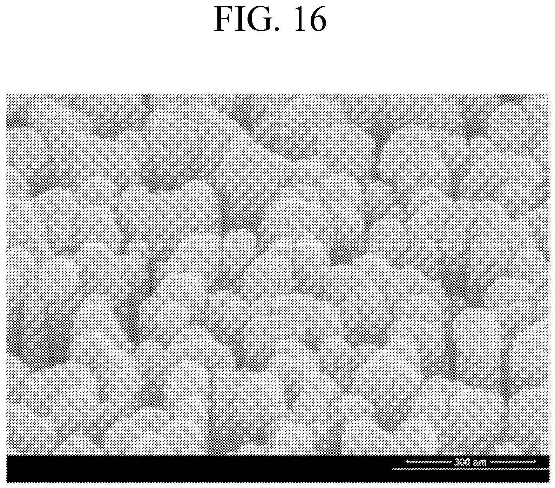

FIGS. 15 and 16 illustrate a state in which the third conductivity type semiconductor layer 321a is etched to a depth of 200 nm. FIG. 15 shows a plan view of the etched surface, and FIG. 16 shows a perspective view observed at an oblique angle.

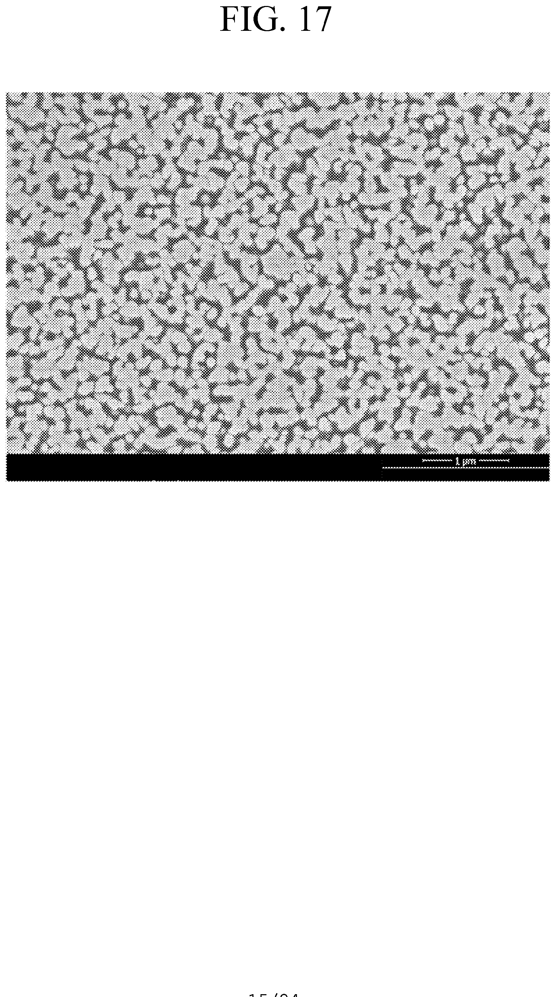

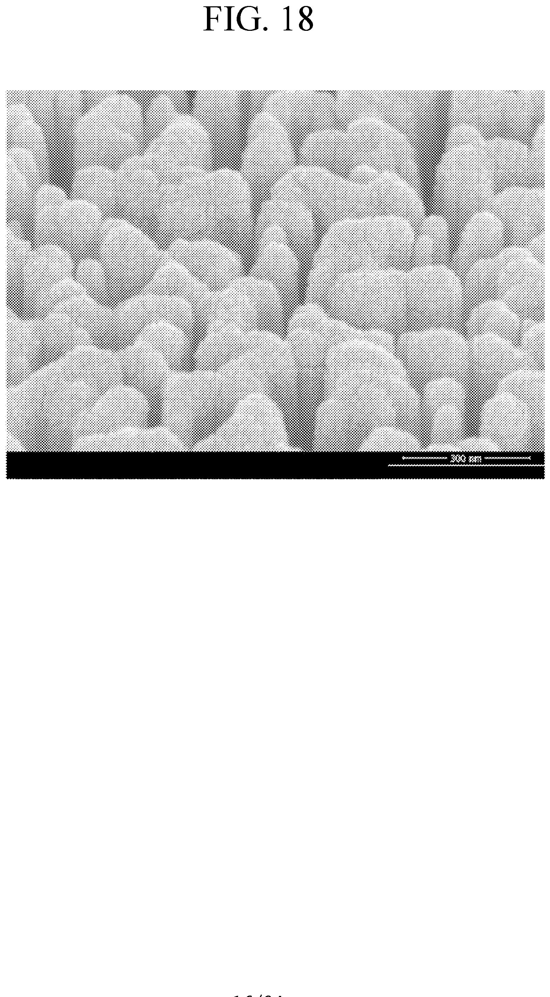

FIGS. 17 and 18 illustrate a state in which the third conductivity type semiconductor layer 321a is etched to a depth of 450 nm. FIG. 17 shows a plan view of the etched surface, and FIG. 18 shows a perspective view observed at an oblique angle.

As described above, it may be confirmed that a rough surface capable of functioning as the light extraction layer 320 is formed by etching. The roughness may be formed to be 1 µm or less.

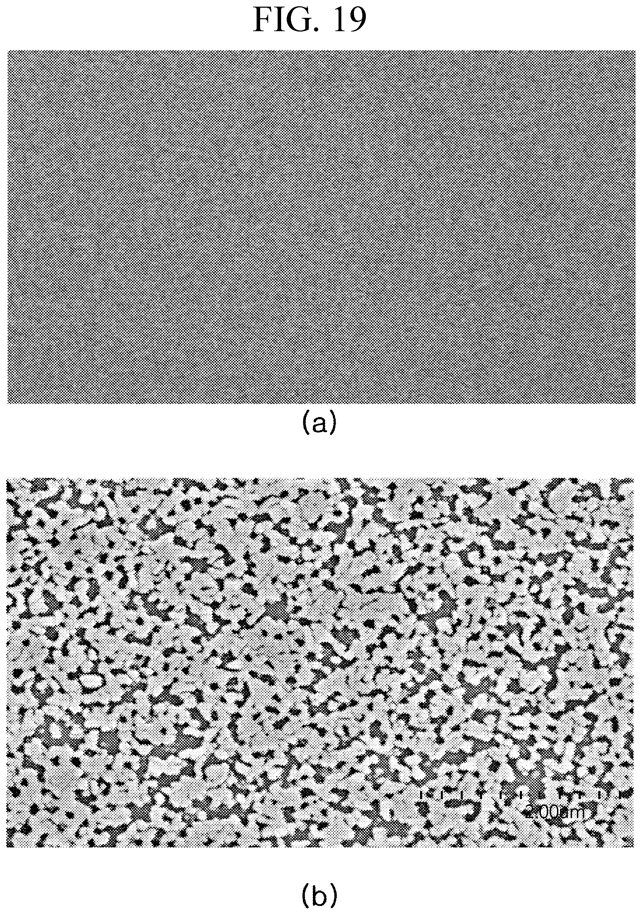

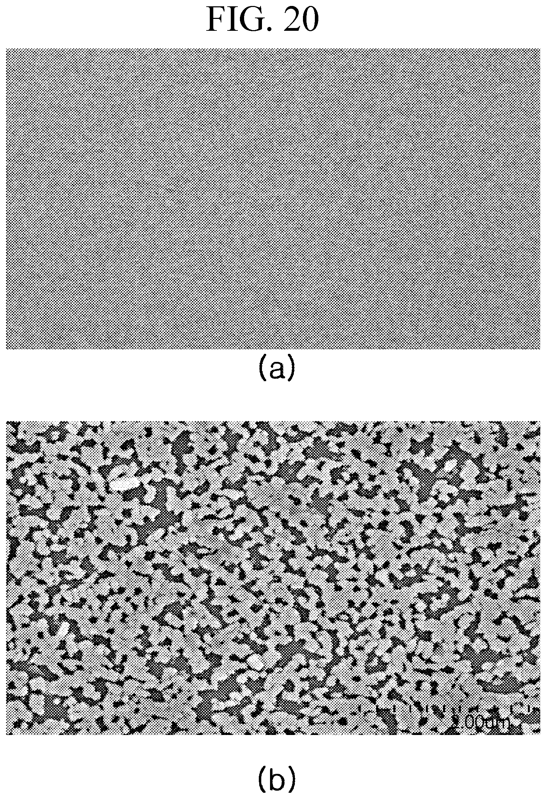

FIGS. 19 and 20 are photographs illustrating changes according to an increase in etching time of the first conductive layer.

In FIGS. 19 and 20, (a) shows an optical microscope image, and (b) shows a scanning electron microscope image.

FIG. 20 illustrates a state in which the planarized first conductive layer 322a is wet-etched for a longer time than in FIG. 19.

Upon confirming color changes of the etched surface through an optical microscope, it may be observed that the colors in FIGS. 19 and 20 are different. Through such color changes of the etched surface, when etching subsequently proceeds, a visual depth may be predicted.

For example, a shape and depth of the random mask 322c according to factors such as concentration of the etchant and processing time may be predicted.

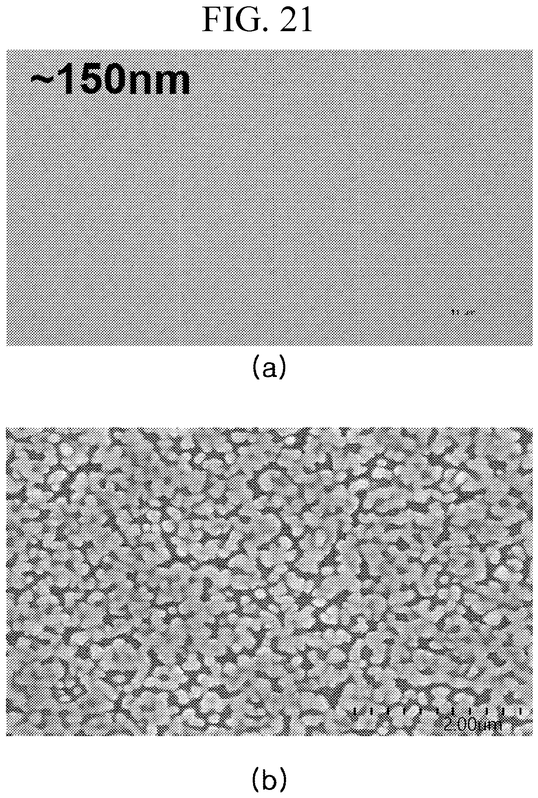

FIGS. 21 to 23 are photographs illustrating changes according to an increase in etching time of the third conductivity type semiconductor layer.

In FIGS. 21 to 23, (a) shows an optical microscope image, and (b) shows a scanning electron microscope image.

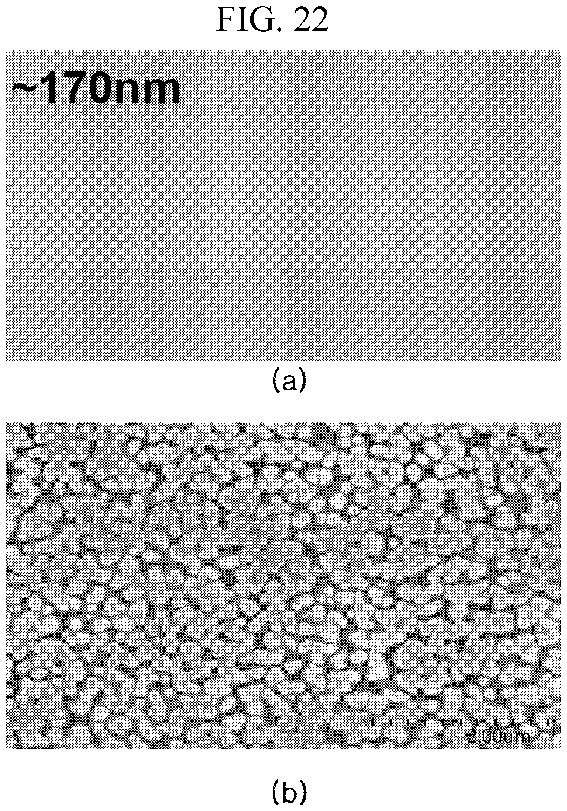

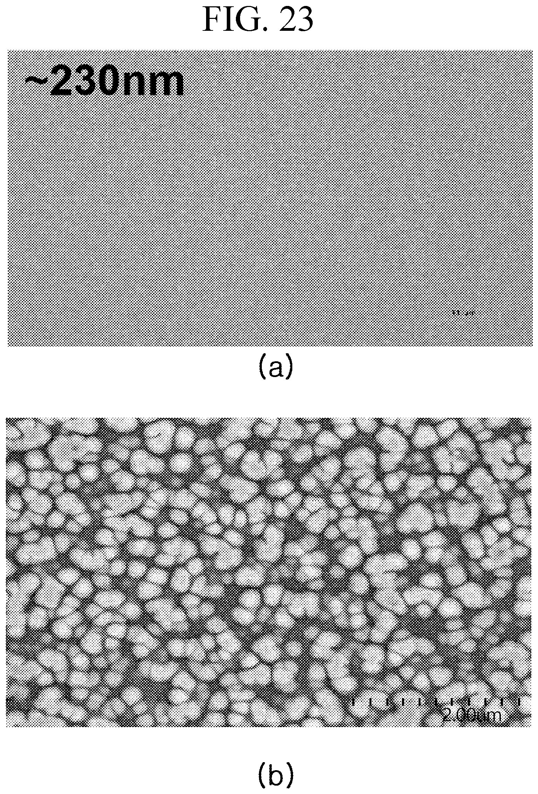

FIG. 21 illustrates a state in which the etch depth reaches 150 nm, FIG. 22 illustrates a state in which the etch depth reaches 170 nm, and FIG. 23 illustrates a state in which the etch depth reaches 230 nm.

Similar to the case of wet-etching the planarized first conductive layer 322a described above, upon confirming color changes of the etched surface through an optical microscope, it may be observed that the colors in FIGS. 21 to 23 are different. Through such color changes of the etched surface, when etching subsequently proceeds, a visual depth may be predicted.

For example, through the color change of the etched surface, surface roughness morphology and depth according to dry etching time may be controlled.

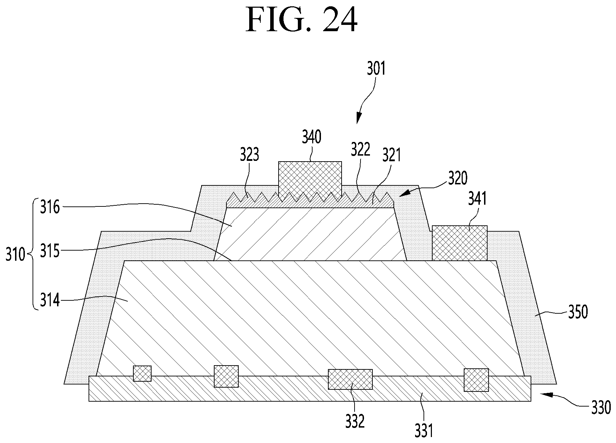

FIG. 24 is a cross-sectional view illustrating a light emitting device according to a second embodiment of the present disclosure.

Referring to FIG. 24, the light emitting device 301 according to the present embodiment may include a semiconductor layer 310 including a first conductivity type semiconductor layer 314, a second conductivity type semiconductor layer 316, and an active layer 315 disposed between the first conductivity type semiconductor layer 314 and the second conductivity type semiconductor layer 316. For example, the semiconductor layer 310 may include the first conductivity type semiconductor layer 314, the active layer 315 disposed on a first surface of the first conductivity type semiconductor layer 314, and the second conductivity type semiconductor layer 316 disposed on the active layer 315. A horizontal cross-sectional shape of the semiconductor layer 310 may be one of a circular shape, an elliptical shape, or a polygonal shape. The light emitting device 301 according to this second embodiment may have a horizontal structure.

For example, the first conductivity type may be n-type and the second conductivity type may be p-type. For example, the first conductivity type semiconductor layer 314 may be an n-type semiconductor layer and the second conductivity type semiconductor layer 316 may be a p-type semiconductor layer. However, embodiments of the present disclosure are not limited thereto.

As an illustrative embodiment, the light emitting device 301 may be a red light emitting device for emitting red light. The red light emitting device may include a GaP-, GaAs-, or InP-based semiconductor. For example, the red light emitting device may include a compound semiconductor material composed of at least one combination of In, Ga, As, and P. However, embodiments of the present disclosure are not limited thereto.

The light extraction layer 320 may be disposed on the second conductivity type semiconductor layer 316. The light extraction layer 320 can improve extraction efficiency of light generated in the semiconductor layer 310. Specifically, light generated in the active layer 312 of the semiconductor layer 310 can be efficiently emitted to the outside of the light emitting device 301 by the action of the light extraction layer 320.

The light extraction layer 320 may include the pillar structure 321 including a plurality of unit pillars 323 disposed on the second conductivity type semiconductor layer 316. The light extraction layer 320 may further include the first conductive layer 322 locally disposed on the unit pillars 323.

The first conductive layer 322 may be locally disposed at an end of each unit pillar 323. For example, the first conductive layer 322 may have a size equal to or smaller than that of the corresponding unit pillar 323. The first conductive layer 322 may be partially disposed on an upper end of the unit pillar 323. The second conductive layer 324 may be further disposed on the first conductive layer 322 (see FIG. 10).

As described above, the first conductive layer 322 or the first contact layer 332, together with the second conductive layer 324, may function as a second contact layer. An electrode pad 340 (a first electrode pad) may be provided on the second contact layer.

The light emitting device 301 may include the metal structure 330 including the reflective layer 331 and the first contact layer 332 on a second surface (lower surface in FIG. 24) of the first conductivity type semiconductor layer 314.

The first contact layer 332 may be at least partially electrically connected to the first conductivity type semiconductor layer 314.

For example, the first contact layer 332 may be disposed to partially form an ohmic contact with the first conductivity type semiconductor layer 314 without covering an entire lower surface thereof. In this case, the reflective layer 331 may be disposed on a portion of the lower surface of the first conductivity type semiconductor layer 314 where the first contact layer 332 is not disposed, such that reflectivity of the light emitting device 301 may be maintained without being significantly reduced by the first contact layer 332.

Meanwhile, a contact layer 341 forming an additional ohmic contact may be provided on a portion of an upper surface of the first conductivity type semiconductor layer 314 that is exposed. The contact layer 341 may form a second electrode pad.

The light emitting device 301 may include a passivation layer 350 protecting side surfaces of the semiconductor layer 310 and the light extraction layer 320.

Other aspects not described herein may be applied in the same manner as described with respect to the first embodiment above.

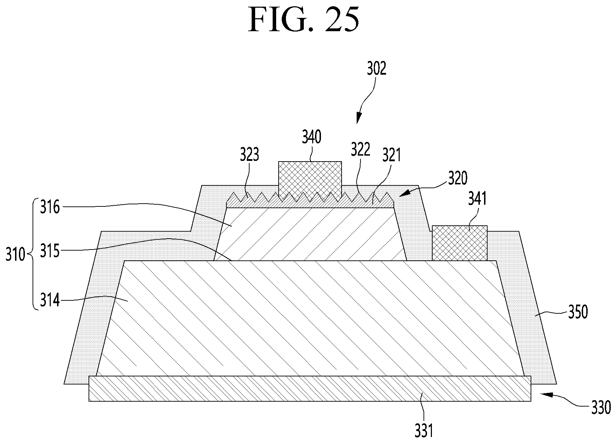

FIG. 25 is a cross-sectional view showing a light emitting device according to a third embodiment of the present disclosure.

Referring to FIG. 25, the light emitting device 302 according to the present embodiment may include a semiconductor layer 310 including a first conductivity type semiconductor layer 314, a second conductivity type semiconductor layer 316, and an active layer 315 disposed between the first conductivity type semiconductor layer 314 and the second conductivity type semiconductor layer 316. As an example, the semiconductor layer 310 may include a first conductivity type semiconductor layer 314, an active layer 315 disposed on a first surface of the first conductivity type semiconductor layer 314, and a second conductivity type semiconductor layer 316 disposed on the active layer 315. The horizontal cross-sectional shape of such a semiconductor layer 310 may be any one of a circular, elliptical, or polygonal shape. The light emitting device 302 according to the third embodiment as described above may have a horizontal structure.

The light extraction layer 320 may be disposed on the second conductivity type semiconductor layer 316. The light extraction layer 320 can improve the extraction efficiency of light generated in the semiconductor layer 310. Specifically, light generated in the active layer 312 of the semiconductor layer 310 can be efficiently emitted to the outside of the light emitting device 301 by the action of the light extraction layer 320.

The light extraction layer 320 may include the pillar structure 321 including a plurality of unit pillars 323 disposed on the second conductivity type semiconductor layer 316. The light extraction layer 320 may further include a first conductive layer 322 locally disposed on the unit pillars 323.

The first conductive layer 322 may be locally disposed at an end portion of the unit pillar 323. As an example, the first conductive layer 322 may be smaller than or equal to the size of the corresponding unit pillar 323. As an example, the first conductive layer 322 may be partially disposed at the upper end portion of the unit pillar 323. Meanwhile, a second conductive layer 324 may be further provided on the first conductive layer 322 (refer to FIG. 10).

The first conductive layer 322 or 332 and the second conductive layer 324 may function as a second contact layer. An electrode pad 340 (a first electrode pad) may be provided on the second contact layer.

The light emitting device 302 may include a metal structure 330 including a reflective layer 331 on a second surface (the lower surface in FIG. 25) of the first conductivity type semiconductor layer 314.

Meanwhile, the contact layer 341 forming an ohmic contact may be provided on a surface where a portion of the upper surface of the first conductivity type semiconductor layer 314 is exposed. The contact layer 341 may constitute a second electrode pad.

The light emitting device 302 may include a passivation layer 350 that protects the side surfaces of the semiconductor layer 310 and the light extraction layer 320.

For other parts not described, the description of the second embodiment described above may be equally applied.

FIG. 26 is a cross-sectional view showing a display apparatus according to an embodiment of the present disclosure.

Referring to FIG. 26, the display apparatus 10 according to the present embodiment may be configured by light emitting devices 300R, 300G, and 300B forming unit sub-pixels being disposed on a wiring substrate 400 on which first electrodes 410 are arranged.

A plurality of first electrodes 410 may be disposed on the wiring substrate 400. Such first electrodes 410 may include a pair of assembly electrodes 411 and 412 described above. These first electrodes 410 may be used as wiring electrodes after the light emitting devices 300R, 300G, and 300B are assembled. The first electrode 410 may be disposed in partitions on the wiring substrate 400. Here, the first electrode 410 may be used as a data electrode (pixel electrode) or a scan electrode (common electrode).

In FIG. 26, three light emitting devices 300R, 300G, and 300B may constitute a unit pixel. In this case, it may include a red light emitting device 300R emitting red light, a green light emitting device 300G emitting green light, and a blue light emitting device 300B emitting blue light. Such unit pixels may be repeatedly provided on the wiring substrate 400.

FIG. 26 illustrates three light emitting devices 300R, 300G, and 300B having the form of the light emitting device 300 according to the first embodiment described above.

Although not shown, the first electrode 410 arranged on the wiring substrate 400 may be connected to a TFT layer provided with a Thin Film Transistor (TFT). A data electrode (pixel electrode) may be connected to such a TFT layer. A detailed description thereof will be omitted.

As an exemplary embodiment, at least one of the upper surface and the lower surface of the light emitting devices 300R, 300G, and 300B may form a circle. As an example, the light emitting devices 300R, 300G, and 300B may have a cylindrical shape or a truncated cone shape.

In order to grant vertical selectivity during assembly of the light emitting devices 300R, 300G, and 300B, the lower area of the light emitting devices 300R, 300G, and 300B may be larger than the upper area. As an example, the area of the surface close to the first contact layer 331 of the light emitting devices 300R, 300G, and 300B may be larger than the area of the surface far from the first contact layer 331.

Meanwhile, an organic partition wall 421 may be disposed between the light emitting devices 300R, 300G, 300B and the first electrode 410. The reflective layer 331 and the first contact layer 332 of the light emitting devices 300R, 300G, and 300B may be insulated by the organic partition wall 421.

In addition, the display apparatus 10 may include a first connection electrode 430 that electrically connects the first electrode 410 and one side of the light emitting devices 300R, 300G, and 300B. Such a first connection electrode 430 may be made of a metal with high electrical conductivity, such as Al, Mo, Cu, Ag, or Pt.

As an exemplary embodiment, the side of the light emitting devices 300R, 300G, and 300B to which the first connection electrode 430 is connected may be lateral with respect to the light emitting layer (active layer; 312) of the light emitting devices 300R, 300G, and 300B. For example, the first connection electrode 430 may be connected in a lateral direction with respect to the plane formed by the light emitting layer 312 of the light emitting devices 300R, 300G, and 300B. This first connection electrode 430 may extend to the side surface of the first conductivity type semiconductor layer 311 of the light emitting devices 300R, 300G, and 300B and be electrically connected to the first conductivity type semiconductor layer 311.

In this case, aluminum (Al) used as the first connection electrode 430 and the reflective layer 332 of the light emitting devices 300R, 300G, and 300B may form an alloy. By forming such an alloy, the thermal/electrical characteristics of the light emitting device and the display apparatus can be improved.

Referring to FIG. 26, the first connection electrode 430 may be provided on both sides of the light emitting devices 300R, 300G, and 300B. In some cases, the first connection electrode 430 may be provided to cover along the side surfaces of the light emitting devices 300R, 300G, and 300B.

A planarization layer 420 may be disposed on the first connection electrode 430 and the sides of the light emitting devices 300R, 300G, and 300B. The planarization layer 420 may coat the first connection electrode 430 and the light emitting devices 300R, 300G, and 300B. The planarization layer 420 may have a height corresponding to the upper side of the light emitting devices 300R, 300G, and 300B, or may be provided with a higher height.

A second connection electrode 440, which is disposed on the planarization layer 420 and electrically connected to the other side of the light emitting devices 300R, 300G, and 300B, may be disposed. For example, such a second connection electrode 440 may include a transparent electrode such as ITO. Therefore, light emitted from the light emitting devices 300R, 300G, and 300B can be emitted to the outside through the second connection electrode 440.

Referring to FIG. 26, the second connection electrode 440 may be partially disposed on the light emitting devices 300R, 300G, and 300B. In some cases, these second connection electrodes 440 may be connected to each other by an additional second electrode (not shown).

FIG. 27 is a cross-sectional view showing a display apparatus according to another embodiment of the present disclosure.

Referring to FIG. 27, the display apparatus 10 according to the present embodiment may be configured by light emitting devices 300R, 300G, and 300B forming unit sub-pixels being disposed on a wiring substrate 500 on which first electrodes 510 are arranged.

A plurality of first electrodes 510 may be disposed on the wiring substrate 500. Such first electrodes 510 may be used as wiring electrodes. The first electrode 510 may be disposed in partitions on the wiring substrate 500. Here, the wiring electrode may be used as a data electrode (pixel electrode) or a scan electrode (common electrode).

In FIG. 27, three light emitting devices 300R, 300G, and 300B may constitute a unit pixel. In this case, the light emitting devices may include a red light emitting device 300R emitting red light, a green light emitting device 300G emitting green light, and a blue light emitting device 300B emitting blue light. Such unit pixels may be repeatedly provided on the wiring substrate 500.

FIG. 27 illustrates three light emitting devices 300R, 300G, and 300B having the form of the light emitting device 300 according to the first embodiment described above.

Although not shown, the first electrode 510 arranged on the wiring substrate 500 may be connected to a TFT layer provided with a Thin Film Transistor (TFT). A data electrode (pixel electrode) may be connected to such a TFT layer. A detailed description thereof will be omitted.

As an exemplary embodiment, at least one of the upper surface and the lower surface of the light emitting devices 300R, 300G, and 300B may form a circle. As an example, the light emitting devices 300R, 300G, and 300B may have a cylindrical shape or a truncated cone shape.

In order to grant vertical selectivity during assembly of the light emitting devices 300R, 300G, and 300B, the lower area of the light emitting devices 300R, 300G, and 300B may be larger than the upper area. As an example, the area of the surface close to the first contact layer 331 of the light emitting devices 300R, 300G, and 300B may be larger than the area of the surface far from the first contact layer 331.

Meanwhile, an organic partition wall 521 may be disposed between the light emitting devices 300R, 300G, and 300B and the first electrode 510. The reflective layer 331 and the first contact layer 332 of the light emitting devices 300R, 300G, and 300B may be insulated by the organic partition wall 521.

In addition, the display apparatus 10 may include a first connection electrode 530 that electrically connects the first electrode 510 and one side of the light emitting devices 300R, 300G, and 300B. Such a first connection electrode 530 may be made of a metal with high electrical conductivity, such as Al, Mo, Cu, Ag, or Pt.

As an exemplary embodiment, the side of the light emitting devices 300R, 300G, and 300B to which the first connection electrode 530 is connected may be lateral with respect to the light emitting layer (active layer; 312) of the light emitting devices 300R, 300G, and 300B. For example, the first connection electrode 530 may be connected in a lateral direction with respect to the plane formed by the light emitting layer 312 of the light emitting devices 300R, 300G, and 300B. This first connection electrode 530 may extend to the side surface of the first conductivity type semiconductor layer 311 of the light emitting devices 300R, 300G, and 300B and be electrically connected to the first conductivity type semiconductor layer 311.

In this case, aluminum (Al) used as the first connection electrode 530 and the reflective layer 332 of the light emitting devices 300R, 300G, and 300B may form an alloy. By forming such an alloy, the thermal/electrical characteristics of the light emitting device and the display apparatus can be improved.

Referring to FIG. 27, the first connection electrode 530 may be provided on both sides of the light emitting devices 300R, 300G, and 300B. In some cases, the first connection electrode 530 may be provided to cover along the side surfaces of the light emitting devices 300R, 300G, and 300B.

A planarization layer 520 may be disposed on the first connection electrode 530 and the sides of the light emitting devices 300R, 300G, and 300B. The planarization layer 520 may coat the first connection electrode 530 and the light emitting devices 300R, 300G, and 300B. The planarization layer 520 may have a height corresponding to the upper side of the light emitting devices 300R, 300G, and 300B, or may be provided with a higher height.

A second connection electrode 540, which is disposed on the planarization layer 520 and electrically connected to the other side of the light emitting devices 300R, 300G, and 300B, may be disposed. For example, such a second connection electrode 540 may include a transparent electrode such as ITO. Therefore, light emitted from the light emitting devices 300R, 300G, and 300B can be emitted to the outside through the second connection electrode 540.

Referring to FIG. 27, the second connection electrode 540 may be partially disposed on the light emitting devices 300R, 300G, and 300B. In some cases, these second connection electrodes 540 may be connected to each other by an additional second electrode (not shown).

According to the embodiments of the present disclosure as described above, the light extraction structure of the light emitting devices 300, 301, and 302 can be efficiently implemented through the light extraction layer 320, thereby improving the light extraction efficiency of the light emitting devices 300, 301, and 302.

In addition, along with the improvement in the light extraction efficiency of the light emitting devices 300, 301, and 302, when the light emitting devices 300, 301, and 302 are used as display pixels, the efficiency of the display apparatus 10 can be improved together.

Furthermore, it is possible to improve a phenomenon in which the color viewing angle of the display apparatus 10 becomes non-uniform depending on the light emitting devices 300, 301, and 302.

The above description is merely illustrative of the technical ideas of the present disclosure, and those of ordinary skill in the art to which the present disclosure pertains will be able to make various modifications and variations without departing from the essential characteristics of the present disclosure.

Accordingly, the embodiments disclosed in the present disclosure are intended to explain rather than limit the technical ideas of the present disclosure, and the scope of the technical ideas of the present disclosure is not limited by these embodiments.

The scope of protection of the present disclosure should be interpreted by the following claims, and all technical ideas within the equivalent range should be interpreted as being included in the scope of rights of the present disclosure.

### [Industrial Applicability]

According to the present disclosure, a semiconductor light emitting device such as a micro-LED and a display apparatus using the same can be provided.

## Claims

1. A light emitting device comprising:
a first conductivity type semiconductor layer;
an active layer disposed on a first surface of the first conductivity type semiconductor layer;
a second conductivity type semiconductor layer disposed on the active layer;
a reflective layer disposed on a second surface of the first conductivity type semiconductor layer; and
a light extraction layer disposed on the second conductivity type semiconductor layer,
wherein the light extraction layer includes:
a pillar structure including a plurality of unit pillars disposed on the first conductivity type semiconductor layer; and
a first conductive layer locally disposed on the unit pillars.

2. The light emitting device of claim 1, wherein the pillar structure includes a third conductivity type semiconductor.

3. The light emitting device of claim 2, wherein the third conductivity type semiconductor includes the same semiconductor material as the second conductivity type semiconductor layer.

4. The light emitting device of claim 1, wherein the first conductive layer includes a transparent conductive oxide.

5. The light emitting device of claim 1, further comprising a second conductive layer disposed on the first conductive layer.

6. The light emitting device of claim 5, wherein the second conductive layer is further disposed on the pillar structure.

7. The light emitting device of claim 5, wherein the second conductive layer includes a transparent conductive oxide.

8. The light emitting device of claim 1, wherein the pillar structure has a structure etched using the first conductive layer as a mask.

9. The light emitting device of claim 1, further comprising a first contact layer of which at least a portion is discontinuously and electrically connected to the second surface of the first conductivity type semiconductor layer.

10. The light emitting device of claim 9, wherein the first contact layer forms an ohmic contact with the first conductivity type semiconductor layer at a portion discontinuously and electrically connected to the second surface.

11. The light emitting device of claim 1, wherein the first conductive layer functions as a second contact layer for the second conductivity type semiconductor layer.

12. A method of manufacturing a light emitting device including a semiconductor layer which includes a first conductivity type semiconductor layer, a second conductivity type semiconductor layer, a third conductivity type semiconductor layer, and an active layer disposed between the first conductivity type semiconductor layer and the second conductivity type semiconductor layer, the method comprising:
forming a first conductive layer on the third conductivity type semiconductor layer;
etching the first conductive layer; and
etching the third conductivity type semiconductor layer using the first conductive layer as a mask to form a light extraction layer including a pillar structure including a plurality of unit pillars.

13. The method of claim 12, wherein the first conductive layer includes a transparent conductive oxide.

14. The method of claim 12, further comprising forming a second conductive layer on the first conductive layer and the pillar structure.

15. A display apparatus using a light emitting device, comprising:
a wiring substrate on which first electrodes are arranged;
a light emitting device including a semiconductor layer forming a unit sub-pixel, the light emitting device being disposed on the wiring substrate;
a first connection electrode electrically connecting the first electrode and one side of the semiconductor layer of the light emitting device;
a planarization layer covering the light emitting device and the first connection electrode; and
a second connection electrode disposed on the planarization layer and electrically connecting with the other side of the semiconductor layer of the light emitting device,
wherein the light emitting device includes a light extraction layer disposed on the semiconductor layer,
wherein the light extraction layer includes: a pillar structure including a plurality of unit pillars disposed on the semiconductor layer; and a first conductive layer locally disposed on the unit pillars.
